# EUROPEAN PATENT SPECIFICATION

(11) **EP 1 458 026 B1**
(45) Date of publication and mention of the grant of the patent: **26.11.2008**
(21) Application number: 04250772.3
(22) Date of filing: 12.02.2004
(51) Int. Cl.: H01L 27/10

(54) **Low temperature processing of PCMO thin film on an Iridium layer for RRAM application**
Niedrigtemperaturverfahren zur Herstellung eines PCMO Dünnfilms auf einer Iridiumschicht für RRAM Anwendungen
Procédé de fabrication à basse température d'un film mince du type PCMO sur une couche Iridium pour application RRAM

(30) Priority: 10.03.2003 US 384846
(43) Date of publication of application: 15.09.2004
(73) Proprietor: Sharp Kabushiki Kaisha, Osaka 545-8522 (JP)
(72) Inventor: Zhang, Fengyan, Vancouver, WA 98683 (US); Zhuang, Weiwei, Vancouvert, WA 98683 (US); Pan, Wei, Vancouver, WA 98683 (US); Hsu, Sheng Teng, Camas, WA 98607 (US)
(74) Representative: Brown, Kenneth Richard

(56) References cited:
- EP-A- 1 220 318
- EP-A- 1 335 417
- EP-A- 1 369 501
- WO-A-00/01000
- WO-A-00/70685
- WO-A-00/77832
- US-A1- 2003 003 674

## Description

### Field of the Invention

This invention relates to a method of growing a PCMO thin film on an iridium layer for RRAM applications, and specifically, to a technique for depositing multiple layers of Pr_{0.7}Ca_{0.3}MnO₃ (PCMO) to provide a resistance layer.

### Background of the Invention

An electrically-programmable resistance, non-volatile memory device, which operates at room temperature which uses a PCMO thin film on a platinum substrate was demonstrated by Zhuang, et al. in US Patent 6,664,117, entitled *Method for Resistance Memory Metal Oxide Thin Film Deposition*. That patent describes the fabrication steps of PCMO thin film on a substrate.

A PCMO thin film grown on a platinum substrate at a low heat treatment temperature exhibits amorphous or polycrystalline structure. A resistor incorporating such a PCMO thin film may be reversibly programmed to a high or a low resistance state by a unipulse having different pulse widths. A technique for forming and programming such a structure is described herein.

EP 1 369 501 discloses a method of forming a perovskite thin film includes preparing a perovskite precursor solution; preparing a silicon substrate for deposition of a perovskite thin film, including forming a bottom electrode on the substrate; securing the substrate in a spin-coating apparatus and spinning the substrate at a predetermined spin rate; injecting a perovskite precursor solution into the spin-coating apparatus thereby coating the substrate with the perovskite precursor solution to form a coated substrate; baking the coated substrate at temperatures which increase incrementally from about 90° C to 300° C; and annealing the coated substrate at a temperature of between about 500° C to 800° C for between about five minutes to fifteen minutes.

WO 00/01000 discloses a ferroelectric thin film capacitor for use in electronic memories with smooth electrodes permitting comparatively stronger polarization, less fatigue, and less imprint, as the ferroelectric capacitor ages. The smooth electrode surfaces are produced by DC reactive sputtering.

US 2003/0003674 discloses resistive cross point memory devices. The memory device comprises an active layer of perovskite material interposed between upper electrodes and lower electrodes. A bit region located within the active layer at the cross point of an upper electrode and a lower electrode has a resistivity that can change through a range of values in response to application of one, or more, voltage pulses. Voltage pulses may be used to increase the resistivity of the bit region, decrease the resistivity of the bit region, or determine the resistivity of the bit region. Memory circuits are provided to aid in the programming and read out of the bit region.

### Summary of the Invention

According to the present invention there is provided a method of applying a PCMO thin film on an iridium layer for use in a RRAM device, comprising: preparing a substrate; depositing a barrier layer on the substrate; depositing a layer of iridium on the barrier layer; spin coating a layer of PCMO on the layer of iridium; baking the layer of PCMO and substrate in a three-step baking process; post-bake annealing the substrate and the layer of PCMO in a RTP chamber; repeating said spin coating, baking and annealing steps until the layer of PCMO has a desired thickness; annealing the substrate and the layer of PCMO; depositing a top electrode; and completing the RRAM device, wherein the baking temperature is higher in the second step than in the first step, and is higher in the third step than in the second step.

It is desirable to provide a method of deposition of PCMO thin film on an Ir substrate for use in RRAM applications.

It is also desirable to provide a RRAM which may be programmed by a pulse having a varying pulse width.

This summary and objectives of the invention are provided to enable quick comprehension of the nature of the invention. A more thorough understanding of the invention may be obtained by reference to the following detailed description of the preferred embodiment of the invention in connection with the drawings.

### Brief Description of the Drawing

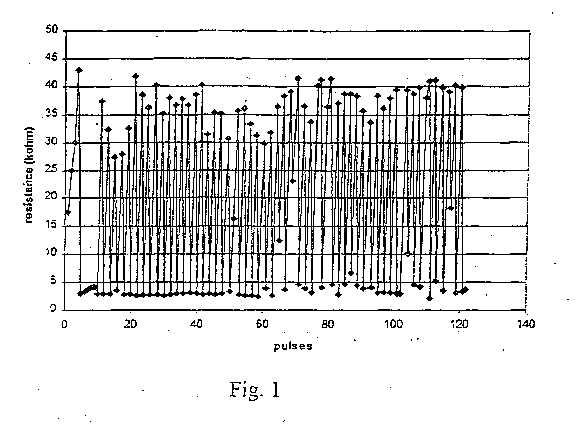

Fig. 1 is a graph depicting the resistance switch properties of a PCMO thin film deposited on an Ir layer according to the method of the invention.

### Detailed Description of the Preferred Embodiments

Iridium is deposited on a substrate having a top layer of silicon, silicon dioxide, or polysilicon. A barrier layer of Ta, TaN, Ti, TiN, TiAIN, TaAlN, TiSiN, TaSiN, TiAl, or TiAlN is formed on the substrate by PVD, CVD or MOCVD, to a thickness of between about 10 nm to 100 nm. A layer of iridium is deposited on the barrier layer by PVD, CVD or MOCVD, to a thickness of between about 50 nm to 500 nm. A first layer of Pr_{0.7}Ca_{0.3}MnO₃ (PCMO) thin film is spin coated on the iridium surface. A number of precursor may be used to form the PCMO thin film, such as Pr(CH₃CO₂)₃·H₂O, Ca(CH₃CO₂)₂·H₂O, or Mn(III) (CH₃CO₂)₃·2H₂O, in an acetic acid solvent. Once a layer of PCMO is deposited by spin coating, the film and substrate are baked in a three step process, wherein the first baking step includes baking at between about 50°C to 150°C for between about ten seconds and one hour; the second step includes baking at a temperature of between about 100°C to 200°C for between about ten seconds and one hour, and the third step includes baking at a temperature of between about 150°C to 300°C for between about ten seconds and one hour. Different baking temperatures are employed in the three steps; preferably, the temperature is increased when progressing from the first step to the second step and when progressing from the second step to the third step. This three step baking process provides for better material structure that does a single baking step or a single annealing step. After the baking steps are completed, the film is rapid thermal processed (RTP) in an annealing step after each spin coating and baking step at a temperature of between about 400°C to 550°C for between about ten seconds to one hour. The coating-baking-RTP process is repeated until a number of PCMO coating have been deposited and the layer of PCMO has reached the desired thickness, generally between about 10 nm and 100 nm, which typically requires between one and fifty spin-coating-baking-RTP cycles.

The layer of PCMO and substrate are put in a RTP chamber for a post-bake annealing heat treatment, at a temperature between about 450° C to 550° C for a time of between about one minute to twenty-four hours. A platinum, iridium, or other noble metal layer, or a metal oxide top electrode is then deposited on the PCMO thin film and patterned using, either shallow mask or a dry etching process. The post-bake annealing step may also be performed after the top electrode is deposited and etched.

Fig. 1 depicts the resistance switching properties of PCMO thin film deposited on an iridium substrate. This film was RTP pre-annealed at 500° C for five minutes for each coating and RTP annealed at 550° C for fifteen minutes. There are three layers of PCMO in the device. The write condition is 5V, 200ns and the reset condition is -3.5V, 4us. The write resistance is about 10 times higher than the reset resistance.

Thus, a method for low temperature processing of PCMO thin film on Ir substrate for RRAM application has been disclosed. It will be appreciated that further variations and modifications thereof may be made within the scope of the invention as defined in the appended claims.

## Claims

1. A method of applying a PCMO thin film on an iridium layer for use in a RRAM device, comprising:
preparing a substrate;
depositing a barrier layer on the substrate;
depositing a layer of iridium on the barrier layer;
spin coating a layer of PCMO on the layer of iridium;
baking the layer of PCMO and substrate in a three-step baking process;
post-bake annealing the substrate and the layer of PCMO in a RTP chamber;
repeating said spin coating, baking and annealing steps until the layer of PCMO has a desired thickness;
annealing the substrate and the layer of PCMO;
depositing a top electrode; and
completing the RRAM device, wherein the baking temperature is higher in the second step than in the first step, and is higher in the third step than in the second step.

2. The method of claim 1 wherein said preparing a substrate includes preparing a silicon substrate having a top layer taken from the group of materials consisting of silicon, silicon dioxide and polysilicon.

3. The method of claim 1 wherein said depositing a barrier layer includes depositing a barrier layer taken from the group of material consisting of Ta, TaN, Ti, TiN, TiAIN, TaAlN, TiSiN, TaSiN, TiAl and TiAlN.

4. The method of claim 1 wherein said spin coating includes selecting a PCMO precursor taken from the group of precursors consisting of Pr(CH₃CO₂)₃.H₂O, Ca(CH₃CO₂)₂. H₂O, and Mn(III) (CH₃CO₂)₃.2H₂O, in an acetic acid solvent.

5. The method of claim 1 wherein said baking the layer of PCMO and substrate in a three-step baking process includes a first baking step at a temperature of between about 50° C to 150° C for between about ten seconds and one hour; a second baking step at a temperature of between about 100° C to 200° C for between about ten seconds and one hour, and a third baking step at a temperature of between about 150° C to 300° C for between about ten seconds and one hour.

6. The method of claim 1 wherein said post-bake annealing the substrate and the layer of PCMO in a RTP chamber includes annealing at a temperature of between about 400° C to 550° C for between about ten seconds to one hour.

7. The method of claim 1 wherein said annealing the substrate and the layer of PCMO includes annealing the substrate and the layer of PCMO at a temperature between about 450° C to 550° C for a time of between about one minute to twenty-four hours.

8. The method of claim 1,
wherein the spin coating includes selecting a PCMO precursor taken from the group of precursors consisting of Pr(CH₃CO₂)₃.H₂O, Ca(CH₃CO₂)₂.H₂O, and Mn(III) (CH₃CO₂)₃.2H₂O, in an acetic acid solvent;
the baking the layer of PCMO and substrate in a three-step baking process includes a first baking step at a temperature of between about 50° C to 150° C for between about ten seconds and one hour; a second baking step at a temperature of between about 100° C to 200° C for between about ten seconds and one hour, and a third baking step at a temperature of between about 150° C to 300° C for between about ten seconds and one hour; and
the post-bake annealing the substrate and the layer of PCMO in a RTP chamber includes annealing at a temperature of between about 400° C to 550° C for between about ten seconds to one hour.

9. The method of claim 8 wherein said preparing a substrate includes preparing a silicon substrate having a top layer taken from the group of materials consisting of silicon, silicon dioxide and polysilicon.

10. The method of claim 8 wherein said depositing a barrier layer includes depositing a barrier layer taken from the group of material consisting of Ta, TaN, Ti, TiN, TiAlN, TaAlN, TiSiN, TaSiN, TiAl and TiAIN.

11. The method of claim 8 wherein said annealing the substrate and the layer of PCMO includes annealing the substrate and the layer of PCMO at a temperature between about 450° C to 550° C for a time of between about one minute to twenty-four hours.

## Patentansprüche

1. Verfahren zum Aufbringen eines PCMO-Dünnfilms auf eine Iridiumschicht zur Verwendung in einer RRAM-Vorrichtung, umfassend:
Herstellen eines Substrats;
Abscheiden einer Sperrschicht auf dem Substrat;
Abscheiden einer Iridiumschicht auf der Sperrschicht;
Spinbeschichten einer Schicht von PCMO auf die Iridiumschicht;
Backen der PCMO-Schicht und des Substrats in einem dreistufigen Backverfahren;
Härten des Substrats und der PCMO-Schicht nach dem Backen in einer RTP-Kammer;
Wiederholen der Spinbeschichtungs-, Back- und Härtungsschritte bis die PCMO-Schicht die gewünschte Dicke aufweist;
Härten des Substrats und der PCMO-Schicht;
Abscheiden einer oberen Elektrode und
Vervollständigen der RRAM-Vorrichtung, wobei die Backtemperatur im zweiten Schritt höher ist als im ersten Schritt, und im dritten Schritt höher ist als im zweiten Schritt.

2. Verfahren nach Anspruch 1, wobei das Herstellen des Substrats die Herstellung eines Siliciumsubstrats mit einer Oberschicht, ausgewählt aus der Gruppe von Materialien, bestehend aus Silicium, Siliciumdioxid und Polysilicium, umfasst.

3. Verfahren nach Anspruch 1, wobei die Abscheidung der Sperrschicht die Abscheidung einer Sperrschicht, ausgewählt aus der Gruppe von Materialien, bestehend aus Ta, TaN, Ti, TiN, TiAlN, TaAlN, TiSiN, TaSiN, TiAl und TiAlN umfasst.

4. Verfahren nach Anspruch 1, wobei das Spinbeschichten das Auswählen eines PCMO-Vorläufers, ausgewählt aus der Gruppe von Vorläufern, bestehend aus Pr(CH₃CO₂)₃.H₂O, Ca(CH₃CO₂)₂.H₂O und Mn(III)(CH₃CO₂)₃. 2H₂O, in einem Essigsäurelösungsmittel, umfasst.

5. Verfahren nach Anspruch 1, wobei das Backen der PCMO-Schicht und des Substrats in einem dreistufigen Backverfahren einen ersten Backschritt bei einer Temperatur zwischen etwa 50°C und 150°C für zwischen etwa 10 Sekunden und einer Stunde; einen zweiten Backschritt bei einer Temperatur zwischen etwa 100°C und 200°C für zwischen etwa 10 Sekunden und einer Stunde; und einen dritten Backschritt bei einer Temperatur zwischen etwa 150°C und 300°C für zwischen etwa 10 Sekunden und einer Stunde umfasst.

6. Verfahren nach Anspruch 1, wobei die Härtung des Substrats und der PCMO-Schicht in einer RTP-Kammer nach dem Backen das Härten bei einer Temperatur zwischen etwa 400°C und 550°C für zwischen etwa 10 Sekunden und einer Stunde umfasst.

7. Verfahren nach Anspruch 1, wobei das Härten des Substrats und der PCMO-Schicht das Härten des Substrats und der PCMO-Schicht bei einer Temperatur zwischen etwa 450°C und 550°C für eine Zeit zwischen etwa 1 Minute und vierundzwanzig Stunden umfasst.

8. Verfahren nach Anspruch 1,
wobei das Spinbeschichten das Auswählen eines PCMO-Vorläufers, ausgewählt aus der Gruppe von Vorläufern, bestehend aus Pr(CH₃CO₂)₃.H₂O, Ca(CH₃CO₂)₂.H₂O und Mn(III)(CH₃CO₂)₃.2H₂O, in einem Essigsäurelösungsmittel, umfasst;
das Backen der PCMO-Schicht und des Substrats in einem dreistufigen Backverfahren einen ersten Backschritt bei einer Temperatur zwischen etwa 50°C und 150°C für zwischen etwa 10 Sekunden und einer Stunde; einen zweiten Backschritt bei einer Temperatur zwischen etwa 100°C und 200°C für zwischen etwa 10 Sekunden und einer Stunde; und einen dritten Backschritt bei einer Temperatur zwischen etwa 150°C und 300°C für zwischen etwa 10 Sekunden und einer Stunde umfasst; und
das Härten des Substrats und der PCMO-Schicht in einer RTP-Kammer nach dem Backen das Härten bei einer Temperatur zwischen etwa 400°C und 550°C für zwischen etwa 10 Sekunden und einer Stunde umfasst.

9. Verfahren nach Anspruch 8, wobei die Herstellung eines Substrats die Herstellung eines Siliciumsubstrats mit einer Oberschicht, ausgewählt aus der Gruppe von Materialien, bestehend aus Silicium, Siliciumdioxid und Polysilicium umfasst.

10. Verfahren nach Anspruch 8, wobei die Abscheidung der Sperrschicht die Abscheidung einer Sperrschicht, ausgewählt aus der Gruppe von Materialien, bestehend aus Ta, TaN, Ti, TiN, TiAlN, TaAlN, TiSiN, TaSiN, TiAl und TiAlN umfasst.

11. Verfahren nach Anspruch 8, wobei das Härten des Substrats und der PCMO-Schicht das Härten des Substrats und der PCMO-Schicht bei einer Temperatur zwischen etwa 450°C und 550°C für eine Zeit zwischen etwa 1 Minute und vierundzwanzig Stunden umfasst.

## Revendications

1. Procédé d'application d'un film mince de PCMO sur une couche d'iridium pour l'utiliser dans un dispositif RRAM, comportant les étapes consistant à :
préparer un substrat ;
déposer une couche d'arrêt sur le substrat ;
déposer une couche d'iridium sur la couche d'arrêt ;
déposer par centrifugation un film de PCMO sur la couche d'iridium ;
soumettre le film de PCMO et le substrat à une cuisson par mise en oeuvre d'un procédé de cuisson à trois étapes ;
effectuer un recuit de post-cuisson, du substrat et du film de PCMO dans une chambre de traitement thermique rapide (RTP) ;
répéter lesdites étapes de dépôt par centrifugation, de cuisson et de recuit jusqu'à ce que le film de PCMO ait atteint une épaisseur souhaitée ;
effectuer le recuit du substrat et du film de PCMO ;
déposer une électrode supérieure ; et
terminer le dispositif RRAM, la température de cuisson étant plus élevée au cours de la deuxième étape qu'au cours de la première, et plus élevée au cours de la troisième étape qu'au cours de la deuxième.

2. Procédé selon la revendication 1, dans lequel ladite étape consistant à préparer un substrat comprend l'étape consistant à préparer un substrat de silicium possédant une couche supérieure constituée d'un matériau appartenant au groupe constitué du silicium, du dioxyde de silicium et de polysilicium.

3. Procédé selon la revendication 1, dans lequel l'étape consistant à déposer une couche d'arrêt comprend l'étape consistant à déposer une couche d'arrêt constituée d'un matériau appartenant au groupe constitué de Ta, TaN, Ti, TiN, TiAlN, TaAlN, TiSiN, TaSiN, TiAl et TiAlN.

4. Procédé selon la revendication 1, dans lequel l'étape consistant à effectuer un dépôt par centrifugation comprend l'étape consistant à choisir un précurseur du PCMO, appartenant au groupe de précurseurs Pr(CH₃CO₂)₃.H₂O, Ca(CH₃CO₂)₂.H₂O et Mn(III)(CH₃CO₂)₃.2H₂O, dans un solvant formé d'acide acétique.

5. Procédé selon la revendication 1, dans lequel ladite étape consistant à soumettre à une cuisson le film de PCMO et le substrat en mettant en oeuvre un procédé de cuisson à trois étapes comprend une première étape de cuisson à une température comprise entre environ 50°C et 150°C pendant une durée comprise entre environ dix secondes et une heure ; une deuxième étape de cuisson à une température comprise entre environ 100°C et 200°C pendant une durée comprise entre environ dix secondes et une heure ; et une troisième étape de cuisson à une température comprise entre environ 150°C et 300°C pendant une durée comprise entre environ dix secondes et une heure.

6. Procédé selon la revendication 1, dans lequel ladite étape consistant à effectuer un recuit de post-cuisson du substrat et du film de PCMO dans une chambre de traitement thermique rapide (RTP) comprend l'étape consistant à effectuer un recuit à une température comprise entre environ 400°C et 550°C pendant une durée comprise entre environ dix secondes et une heure.

7. Procédé selon la revendication 1, dans lequel ladite étape consistant à effectuer un recuit du substrat et du film de PCMO comprend l'étape consistant à effectuer un recuit du substrat et du film de PCMO à une température comprise entre environ 450°C et 550°C pendant une durée comprise entre environ une minute et vingt-quatre heures.

8. Procédé selon la revendication 1,
dans lequel l'étape consistant à déposer par centrifugation comprend l'étape consistant à choisir un précurseur du PCMO dans le groupe de précurseurs constitué de Pr(CH₃CO₂)₃.H₂O, Ca(CH₃CO₂)_{2.}H₂O et Mn(III)(CH₃CO₂)₃.2H₂O, dans un solvant formé d'acide acétique ;
l'étape consistant à soumettre à une cuisson le film de PCMO et le substrat en mettant en oeuvre un procédé de cuisson à trois étapes comprend une première étape de cuisson à une température comprise entre environ 50°C et 150°C pendant une durée comprise entre environ dix secondes et une heure ; une deuxième étape de cuisson à une température comprise entre environ 100°C et 200°C pendant une durée comprise entre environ dix secondes et une heure ; et une troisième étape de cuisson à une température comprise entre 150°C et 300°C pendant une durée comprise entre environ dix secondes et une heure ; et
l'étape consistant à effectuer un recuit de post-cuisson du substrat et du film de PCMO dans une chambre de traitement thermique rapide (RTP) comprend l'étape consistant à effectuer un recuit à une température comprise entre environ 400°C et 550°C pendant une durée comprise entre environ dix secondes et une heure.

9. Procédé selon la revendication 8, dans lequel l'étape consistant à préparer un substrat comprend l'étape consistant à préparer un substrat de silicium possédant une couche supérieure constituée d'un matériau appartenant au groupe constitué du silicium, du dioxyde de silicium et du polysilicium.

10. Procédé selon la revendication 8, dans lequel ladite étape consistant à déposer une couche d'arrêt comprend l'étape consistant à déposer une couche d'arrêt constituée d'un matériau appartenant au groupe constitué de Ta, TaN, Ti, TiN, TiAlN, TaAlN, TiSiN, TaSiN, TiAl et TiAIN.

11. Procédé selon la revendication 8, dans lequel ladite étape consistant à effectuer un recuit du substrat et du film de PCMO comprend l'étape consistant à effectuer un recuit du substrat et du film de PCMO à une température comprise entre environ 450°C et 550°C pendant une durée comprise entre environ une minute et vingt-quatre heures.
